# EUROPÄISCHE PATENTSCHRIFT

(11) **EP 0 483 477 B1**
(45) Veröffentlichungstag und Bekanntmachung des Hinweises auf die Patenterteilung: **17.11.1994**
(21) Anmeldenummer: 91114441.8
(22) Anmeldetag: 28.08.1991
(51) Int. Cl.: G02B 6/22, G02B 6/26, G02B 6/42

(54) **Flexibles, optisches Bauteil für die Übertragung von Licht und die Verwendung des Bauteils**
Flexible optical device for the transmission of light and use of the device
Dispositif optique flexible pour la transmission de lumière et utilisation du dispositif

(30) Priorität: 26.10.1990 DE 4034059
(43) Veröffentlichungstag der Anmeldung: 06.05.1992
(73) Patentinhaber: Heraeus Quarzglas GmbH, D-63405 Hanau (DE)
(72) Erfinder: Klein, Karl-Friedrich, Dr., W-6360 Friedberg/Ockstadt (DE); Schmitt, Clemens, W-8752 Blankenbach (DE); Fabian, Heinz, W-6450 Hanau 7 (DE); Wörner, Karl-Heinz, W-6455 Erlensee (DE); Neu, Walter, Dr., W-3400 Göttingen (DE); Dressel, Martin, Dr., W-3400 Göttingen (DE); Hitzler, Hermine, W-8881 Villenbach (DE); Leclerc, Norbert, W-7800 Freiburg (DE)
(74) Vertreter: Kühn, Hans-Christian

(56) Entgegenhaltungen:
- EP-A- 0 192 164
- GB-A- 2 095 422
- US-A- 4 641 912
- LASER UND OPTOELEKTRONIK, Bd. 20, Nr. 4, 1988, Stuttgart, DE, Seiten 58-61 ; Greulich et al. : "Transport von leistungsstarken UV-Laserpulsen durch Lichtleiter mit variablem Querschnitt (Taper)"
- LASER UND OPTOELEKTRONIK, Bd. 20, Nr. 5, Oktober 1988, Stuttgart, DE ; Hering : "Neues über optische Fasern für gepulste Laser"

## Beschreibung

Die Erfindung betrifft ein flexibles, optisches Bauteil mit einem Kern und einem diesen umhüllenden, eine kleinere Brechzahl als der Kern aufweisenden Mantel, die im wesentlichen aus Quarzglas bestehen, für die Übertragung von ultraviolettem Licht mit großen Leistungsdichten, das in Einstrahlrichtung des zu übertragenen, ultravioletten Lichtes gesehen vor mindestens einem flexiblen, zylindrischen Bereich einen Verjüngungsbereich aufweist, dessen Querschnittsfläche sich in Einstrahlrichtung stetig verkleinert und das eine Einkoppelfläche auf der, einer die ultraviolette Strahlung emittierenden Lichtquelle zugewandten Stirnseite und eine Auskoppelfläche auf der der Lichtquelle abgewandten Stirnseite aufweist.

Die mittels optischer Bauteile übertragbaren optischen Leistungs- und Energiedichten sind begrenzt durch materialspezifische Zerstörschwellen, oberhalb denen die optischen Eigenschaften der Übertragungsmedien irreversibel verändert werden. Insbesondere liegt für die Einkoppelfläche, in die das zu übertragende Licht eingekoppelt wird, die Zerstörschwelle niedriger als für das Vollmaterial des Bauteils in dem das zu Übertragende Licht geführt wird.

Eine Maßnahme zur Verminderung der auf eine Flächeneinheit einwirkenden optischen Energiedichte bei der Einkopplung in einen Lichtwellenleiter ist aus der US-PS 4,641,912 bekannt. Es wird darin eine optische Übertragungsstrecke für die Übertragung von gepulstem Excimer-Laserlicht, das eine Wellenlänge im Bereich zwischen 40 bis 400 Nano-Metern aufweist, für eine Verwendung in der angioplastischen Chirurgie beschrieben. Das der Übertragung des Laserlichts dienende optische Bauteil ist dabei als flexibler, mit einem Kern aus reinem Quarzglas und einem Mantel aus dotiertem Quarzglas bestehender Lichtwellenleiter ausgebildet, dessen Brechzahlverlauf ein Stufenprofil aufweist und dessen Einkoppelseite zum Laser hin trichterförmig erweitert ist. Dabei gestattet die Ausbildung als flexibler Lichtwellenleiter eine variable Lichtführung und die trichterförmige Erweiterung der Einkoppelseite ermöglicht gegenüber einer direkten Einkopplung in die Faserstirnfläche eine Verbreiterung des Lichtflecks und damit bei gleicher Laser-Ausgangsenergie eine Verringerung der Energiedichte auf der Einkoppelfläche. Aufgrund von Totalreflexionen an der Kern/Mantel-Grenzfläche wird das eingekoppelte Laserlicht in den kleineren Querschnitt des Lichtwellenleiters überführt und dadurch die vom Quarzglas aufzunehmende optische Leistungsdichte im Bereich nach der Einkoppelfläche allmählich erhöht. Erst an der Stirnfläche des zylinderförmigen Bereichs des Lichtwellenleiters erreicht die Leistungsdichte ihr Maximum. Dies hat den Vorteil, daß Laserlicht mit einer höheren optischen Leistungsdichte als es die Zerstörschwelle der Einkoppelfläche zuläßt, übertragen werden kann.

Es hat sich jedoch gezeigt, daß gerade die, aufgrund der kleineren Querschnitte und niedrigen Zerstörschwellen flexibler Glasfasern, mittels Lichtwellenleiter übertragbaren optischen Leistungen für viele Anwendungen, insbesondere im Bereich der Materialbehandlung, nicht ausreichend sind, daß in optischen Bauteilen anfänglich übertragbare hohe optische Leistungen durch mechanische Beschädigungen der Bauteile oder Alterungseffekte des die optischen Leistungen aufnehmenden und übertragenden Materials während des Einsatzes der Bauteile abnehmen und daß optimale Bauteil-Geometrien im Hinblick auf größtmögliche optische Leistungsübertragung bei Erhaltung der Bauteil-Flexibilität nicht spezifiziert sind.

Der vorliegenden Erfindung liegt die Aufgabe zugrunde ein flexibles, optisches Bauteil für die Übertragung von ultraviolettem Licht und die Verwendung des Bauteils anzugeben, das hinsichtlich der Zerstörschwellen verbesserte Materialeigenschaften aufweist und dessen geometrische Ausbildung im Hinblick auf die Anregungsbedingungen für das zu übertragende Licht und die Erhaltung der mechanischen und optischen Eigenschaften beim praktischen Einsatz optimiert ist.

Die Aufgabe wird erfindungsgemäß dadurch gelößt, daß das Kern-Glas einen Gehalt an Hydroxyl-Ionen im Bereich von 50 ppm bis 1200 ppm und eine Sauerstoffionen-Defektkonzentration von weniger als 10¹⁷ pro Gramm Glas und das Mantel-Glas einen Gehalt an Hydroxyl-Ionen im Bereich von 50 ppm bis 250 ppm aufweist, daß die Wasserstoff- und/oder Deuteriumkonzentration im Kern-Glas und im Mantel-Glas in einem Bereich von insgesamt 5x10¹⁶ Molekülen pro Kubik-Zentimeter bis 5x10²¹ Molekülen pro Kubik-Zentimeter liegt, daß die Länge (L) des Verjüngungsbereichs einen Wert zwischen dem 15- bis 150-fachen des Kerndurchmessers (Dk) des zylindrischen Bereichs aufweist und daß das Verhältnis von Einkoppelfläche und Kern-Querschnittsfläche des zylindrischen Bereichs einen Wert zwischen 2 und 100 aufweist.

Es hat sich gezeigt, daß mit Hydroxyl-Ionen in einem Bereich zwischen 50 ppm bis 1200 ppm dotiertes Quarzglas in Abhängigkeit von der zu übertragenden Lichtwellenlänge im Vergleich zu hydroxylarmem Quarzglas eine deutliche Erhöhung der Zerstörschwelle gegenüber den von energiereichem, ultraviolettem Licht verursachten Strahlungsschäden aufweist. Über- oder unterschüssiger Sauerstoffionen-Gehalt führt durch eine Unterbrechung der Netzwerkstruktur des Quarzglases zu atomaren Defekten, die die optischen Übertragungseigenschaften des Quarzglases beeinträchtigen. Für die Übertragung von optischen Leistungsdichten nahe der Zerstörschwelle des Quarzglases ist es notwendig, die Konzentration dieser Defekte unterhalb der derzeitigen Nachweisgrenze von 10¹⁷ pro Gramm Quarzglas (gemessen nach der Methode von Shelby) zu halten. Eine Wasserstoff- und/oder Deuterium-Beladung des Quarzglases zwischen 5x10¹⁶ Molekülen pro Kubik-Zentimeter und 5x10²¹ Molekülen pro Kubik-Zentimeter (gemessen mit der Raman-Methode nach: V.S. Khotimchenko et. al., J. Appl. Spectr., Vol. 46, S. 632-635 (1987)) bewirkt ein Ausheilen von atomaren Materialdefekten, beispielsweise durch Reaktion des Wasserstoffs beziehungsweise des Deuteriums mit vorhandenen oder durch das zu übertragene Licht entstandenen Defekten, beispielsweise mit Sauerstofflücken. Dieser Ausheilmechanismus ist auch während des bestimmungsgemäßen Einsatzes des optischen Bauteils wirksam. Im Hinblick auf die durch das Bauteil zu übertragene Lichtleistung, die von der Kern-Querschnittsfläche abhängt und die möglichst groß sein soll, und der wirksamen Einkoppelfläche, die nicht größer als erforderlich sein soll, beträgt das Verhältnis von Einkoppelfläche und Kern-Querschnittsfläche des zylindrischen Bereichs mindestens 2 und höchstens 100. Unter Einkoppelfläche wird dabei die zur Einkopplung des Lichtes nutzbare Fläche, nämlich der Flächenanteil des Kern-Glases an der der Lichtquelle zugekehrten Stirnseite des optischen Bauteils und unter Kern-Querschnittsfläche der Flächenanteil des Kern-Glases an der Grundfläche des zylindrischen Bereichs des Bauteils, verstanden. Die für die Einkopplung der optischen Leistung in das Bauteil geeignete Länge des Verjüngungsbereiches, die bei ausreichend gutem Lichtführungsverhalten möglichst kurz sein soll, hängt vom Durchmesser des Kerns im zylindrischen Bereich ab. Zufriedenstellende Anregungsbedingungen bei weitgehender Erhaltung der Flexibilität des zylindrischen Bereichs für das Bauteil sind vorallem bei einer Länge des Verjüngungsbereichs zwischen dem 15-fachen bis 150-fachen des Kerndurchmessers gegeben.

Im Hinblick auf optimale Anregungsbedingungen hat es sich als vorteilhaft erwiesen, wenn die Länge des Verjüngungsbereichs zwischen dem 50-fachen bis 100-fachen des Kerndurchmessers im zylindrischen Bereich beträgt und wenn das Durchmesserverhältnis von Einkoppelfläche zur Kern-Querschnittsfläche des zylindrischen Bereichs einen Wert zwischen 10 und 50 besitzt.

Es hat sich als günstig erwiesen, das Mantel-Glas des Bauteils mit Fluor und/oder Bor zu dotieren. Brechzahldifferenzen von bis zu 3x10⁻² zwischen dem undotierten Kern-Glas und dem Mantel-Glas sind damit erreichbar. Es hat sich zudem gezeigt, daß Dotierungen von geringsten Mengen der Ionen von Germanium, Gallium, Phosphor, Aluminium, Kohlenstoff und/oder Stickstoff, einen positiven Einfluß auf die optischen Eigenschaften, insbesondere auf die Höhe der Zerstörschwelle des Quarzglases im Hinblick auf Materialschädigungen durch das zu übertragende, ultraviolette Licht, ausüben können. Besonders bewährt hat sich eine Dotierung des Kern-Glases mit Fluor mit einem Anteil von weniger als 0,5 Gewichts-%, mit der Maßgabe, daß bei ausschließlicher Fluor-Dotierung, der Fluor-Gehalt im Kern-Glas so bemessen ist, daß die notwendige Brechzahldifferenz zwischen Kern-Glas und Mantel-Glas erhalten bleibt. Fluor-Dotierungen von weniger als 0,5 Gewichts-Prozent können die Defektbildung im Quarzglas reduzieren. Hinsichtlich einer guten Lichtführung bei ausreichender mechanischer Stabilität und Flexibilität der optischen Bauteile haben sich für das Verhältnis von Mantel- zu Kerndurchmesser im zylindrischen Bereich des Bauteils, Werte zwischen 1,02 und 2 und insbesondere zwischen 1,02 und 1,1 bewährt.

Eine Dotierung von Kern- und/oder Mantel-Glas derart, daß sich die Brechzahlen im Bereich der Kern/Mantel-Grenzfläche allmählich annähern hat sich gegenüber einem stufenförmigen Brechzahlprofil als besonders vorteilhaft erwiesen. Die durch Fehlanpassung der thermischen Eigenschaften, insbesondere der Ausdehnungskoeffizienten und der Viskositäten der beiden Gläser hervorgerufenen Spannungen, die zur Herabsetzung der Zerstörschwellen sowie zur Erhöhung der Defektbildungsrate im Quarzglas führen können, werden dadurch deutlich reduziert. Im Hinblick hierauf hat es sich insbesondere bewährt, daß von der Kern-Brechzahl ausgehend, die Brechzahl in einem Grenzflächenbereich bis auf den Wert der Mantel-Brechzahl so linear abfällt, daß ein mesaförmiges Brechzahlprofil entsteht.

Besonders gute Ergebnisse hinsichtlich der Auskopplung des übertragenen Lichtes aus der Auskoppelfläche werden dadurch erzielt, daß sich die Kern-Querschnittsfläche in einem Übergangsbereich auf der der Lichtquelle abgewandten Seite des Bauteils in Richtung der im Bauteil geführten, ultravioletten Licht-Strahlung gesehen kontinuierlich vergrößert. Bei der Auskopplung von hohen optischen Leistungsdichten an Luft können Schädigungen oder Zerstörungen der Auskoppelfläche, insbesondere entspiegelter Auskoppelflächen, die sehr hohe Anforderungen bezüglich ihrer optischen Qualität erfüllen müssen, auftreten. Durch eine Vergrößerung der Auskoppelfäche und eine damit einhergehende Aufweitung des geführten Lichtstrahles, wird die optische Belastung pro Flächeneinheit der Auskoppelfläche verringert. Dies ermöglicht das Auskoppeln des übertragenen, ultravioletten Lichtes über Entspiegelungsschichten aufweisende Auskoppelflächen, die andernfalls aufgrund hoher optischer Leistungsdichten leicht zerstört würden. Die Ausbildung der Auskoppelfläche mit Entspiegelungsschichten ist insbesondere hinsichtlich einer Verminderung der bei der Auskopplung des übertragenen Lichtes auftretenden Auskoppelverluste vorteilhaft. Es haben sich Durchmesser der Auskoppelflächen zwischen dem 2- und dem 50-fachen des Kerndurchmessers des zylindrischen Bereich besonders bewährt. Der Abstrahlwinkel (Divergenz) bei der Auskopplung des übertragenen Lichtes wird dadurch, im Vergleich zur numerischen Apertur des Bauteils, deutlich reduziert.

Zur Kompensation spezieller Strahlcharakteristiken des einzukoppelnden Lichtes hat es sich als vorteilhaft erwiesen, die Einkoppelfläche gekrümmt zu gestalten. Zur Fokussierung paralleler oder divergenter Lichtstrahlen ist die Einkoppelfläche vorteilhafterweise so ausgebildet, daß der durch die Krümmung erzeugte Fokusdurchmesser höchstens so groß ist wie der Kerndurchmesser im zylindrischen Bereich und der Fokus vor dem Anfang des zylindrischen Bereichs liegt.

Beliebige Abstrahlcharakteristiken lassen sich durch eine gekrümmte Ausbildung der Auskoppelfläche des Bauteils erzeugen.

Es hat sich als günstig erwiesen, zwischen der Lichtquelle und dem Verjüngunsbereich ein Filterelement anzuordnen, dessen Länge mindestens 10 mm beträgt und dessen Durchmesser mindestens so groß ist wie der größte Durchmesser des Verjüngungsbereichs. Dies hat sich insbesondere für breitbandige Lichtübertragungen, wie sie beispielsweise in der Spektroskopie erforderlich sein können, bewährt. Dabei möglicherweise auftretende kurzwellige, ultraviolette Lichtstrahlung hat zwar nur eine geringe Eindringtiefe in Quarzglas, kann jedoch starke Material-Schädigungen verursachen. Die von der Lichtstrahlung verursachten Materialschädigungen sind durch den Vorsatz eines Filterelementes im Einkoppelbereich des Filterelelements konzentriert. Es hat sich bewährt das Filterelement lösbar mit dem Verjüngungsbereich zu verbinden. Dadurch wird ein Austauschen oder eine Regeneration des Filterelementes ermöglicht. Die Anordnung eines Filterelements vor dem Verjüngungsbereich bewirkt eine Schonung des Verjüngungsbereiches vor Strahlenschäden und ermöglicht durch Variation der optischen Eigenschaften des Filterelements eine Anpassung der Lichtstrahlführung an die Einkoppelfläche des Bauteils. Hinsichtlich des Schutzes des Verjüngungsbereichs vor Strahlenschäden durch kurzwellige ultraviolette Strahlung hat sich ein Filterelement, das Titan-dotiertes Quarzglas enthält, als günstig erwiesen. Durch die Dotierung mit Titan wird die Absorptionskante für die ultraviolette Lichtstrahlung zu längeren Wellenlängen verschoben.

Hinsichtlich der Erhaltung der optischen Übertragungseigenschaften des Bauteils über einen längeren Zeitraum hat es sich bewährt, daß das Bauteil eine den Kern und den Mantel umhüllenden Diffusions-Sperrschicht aufweist. Aufgrund der hohen Diffusivität von Wasserstoff bzw. Deuterium in Quarzglas, nimmt die Wasserstoff- bzw. Deuterium-Konzentration in einem damit beladenen Quarzglas und die Wirkung des Ausheilmechanismus dieser Moleküle auf Defektstellen im Glas mit der Zeit ab. Um eine unerwünschte Ausdiffusion aus dem Bauteil zu vermeiden, sind Sperrschichten, die Kohlenstoff oder Metall enthalten besonders geeignet.

Eine äußere, den Kern und den Mantel umhüllende Schutzschicht aus Kunststoff bietet Schutz für das optische Bauteil vor mechanischen Beschädigungen. Besonders geeignet ist eine Schutzschicht, die im wesentlichen aus einem Kunststoff besteht, dessen Brechungsindex kleiner ist als der des Mantel-Glases. Das Heraustreten seitlich gestreuter, energiereicher Lichtstrahlen aus dem Mantel-Glas, die den Kunststoff der Schutzschicht zerstören und damit die mechanische Festigkeit des Bauteils vermindern würden, wird aufgrund von Totalreflexion an der Grenzfläche zwischen Mantel-Glas und Schutzschicht vermindert. Alternativ dazu ist es auch möglich, die Schutzschicht auf einer Strahlenabschirmschicht aus Kunststoff, dessen Brechungsindex kleiner ist als der Brechungsindex des Glases und der eine erhöhte Beständigkeit gegenüber ultravioletten Strahlen aufweist oder auf der Außenoberfläche einer Metallschicht, die den Kern und den Mantel umhüllt und die das Licht an ihrer Innenoberfläche reflektiert, aufzubringen. Die Metallschicht kann dabei gleichzeitig als Diffusionshindernis für ausdiffundierende Teilchen dienen.

Besonders gute Ergebnisse hinsichtlich der mechanischen Festigkeit des optischen Bauteils werden dadurch erzielt, daß das Bauteil eine Druckspannungsschicht aufweist, die den Kern und den Mantel umhüllt und die aus Quarzglas mit einem Titangehalt im Bereich von mindestens 4 Gewichts-Prozent und von höchstens 15 Gewichts-Prozent besteht. Die durch den Titangehalt in der Druckspannungsschicht induzierten, festigkeitserhöhenden Druckspannungen behindern die Entstehung von Oberflächenrissen und erhöhen die mechanische Festigkeit des Bauteils.

Eine Ausführungsform des erfindungsgemäßen optischen Bauteils, das auf seiner, der Lichtquelle abgewandten Seite einen Übergangsbereich aufweist, dessen Kern-Querschnittsfläche sich in Richtung der im Bauteil geführten ultravioletten Lichtstrahlung gesehen kontinuierlich vergrößert, wobei zwischen dem Übergangsbereich und einem mittels des zu übertragenen ultravioletten Lichts zu behandelnden Material ein Übertragungselement angeordnet ist, das im wesentlichen aus Quarzglas besteht und dessen kleinste Querschnittsfläche mindestens so groß ist wie die größte Querschnittsfläche des Übergangsbereichs hat sich besonders bei der Übertragung von ultraviolettem, energiereichem Licht in, das Bauteil chemisch, physikalisch und/oder thermisch belastende Umgebungen, insbesondere bei der Übertragung von ultraviolettem, energiereichem Licht in Bereiche erhöhter Temperatur, bewährt. Unter der Querschnittsfläche des Übertragungselements ist dabei die zur Auskoppelfläche des optischen Bauteils parallel verlaufende Querschnittsfläche zu verstehen. Die Ausbildung des Bauteils mit einem Übertragungselement, das eine größere Querschnittsfläche aufweist als diejenige im zylindrischen Bereich des Bauteils gewährleistet längere Standzeiten des Bauteils in einer das Bauteil chemisch, physikalisch und/oder thermisch belastenden Umgebung, wogegen der dünnere Querschnitt des zylindrischen Bereichs für die Flexibilität des Bauteils und der Lichtführung sorgt. Es hat sich als günstig erwiesen, den Übergangsbereich des Bauteils und das Übertragungselement miteinander zu verbinden, insbesondere miteinander zu verschmelzen. Dies erleichtert die Handhabbarkeit des Bauteils und vereinfacht seine Herstellung.

Das erfindungsgemäße Bauteil hat sich für die Verwendung als Strahlumformer zur Materialbehandlung bewährt. Es verbindet die Fähigkeiten die für die Materialbehandlung erforderlichen sehr hohen Energieleistungen übertragen zu können mit einer größtmöglichen Flexibilität der Lichtführung. Durch Anpassung der Strahlqualität der Lichtquelle, ausgedrückt durch das Produkt von Strahldurchmesser und dazugehöriger Strahldivergenz, an das gleiche Produkt in dem zylindrischen Bereich des Bauteils können hohe Transmissionswerte von über 90% mit homogener Leistungsdichte an der Auskoppelfläche des Bauteiles erreicht werden. Dies wird durch zentrische Einkopplung erreicht, d.h. die Lichtstrahl-Achse und die Achse des zylindrischen Bereichs sind gleich. Außerdem ist notwendig, daß der Fokusdurchmesser nur geringfügig kleiner ist als der Kerndurchmesser des zylindrischen Bereichs und die Strahldivergenz kleiner oder gleich ist dem Akzeptanzwinkel des zylindrischen Bereichs, der gleich der numerischen Apertur bei gegebener Brechzahldifferenz zwischen Kern und Mantel ist. Zur Erzeugung einer ringförmigen Intensitätsverteilung des übertragenen, ultravioletten Lichtes an der Auskoppelfläche wird entweder ein paralleles Lichtbündel in einen Ausleuchtungsbereich der Einkoppelfläche eingekoppelt, dessen Projektionsfläche auf eine Ebene, die senkrecht zur Mantelfläche des zylindrischen Bereichs verläuft, die Projektionsfläche der Grundfläche des zylindrischen Bereichs auf diese Ebene höchstens 50 % überschneidet oder es wird ein fokussiertes Lichtbündel in die Einkoppelfläche so eingekoppelt, daß die bis zur Einkoppelfläche verlängerte Achse des zylindrischen Bereiches die Fokusfläche nicht schneidet. Die Fokusfläche bezeichnet dabei die Ausdehnung des Fokus der eingekoppelten Strahlung quer zur Einstrahlrichtung. Die dadurch erzeugten ringförmigen Intensitätsprofile des übertragenen ultravioletten Lichtes weisen an der Auskoppelfläche sehr hohe Leistungsdichten auf, die mit anderen Anregungsmethoden kaum zu erreichen sind. Diese ringförmigen Intensitätsprofile werden insbesondere zum Schneiden und Trennen fester Materialien eingesetzt. Bei einer transversalen Verschiebung des ringförmigen Licht-Intensitätsprofils über die zu schneidende Material-Fläche mit einer konstanten Verschiebegeschwindigkeit ist das in den Bereich des Intensitätsprofiles gelangende Material annähernd gleichen Leistungsdichten bei annähernd gleichen Verweilzeiten ausgesetzt. Dadurch werden bei der erfindungsgemäßen Verwendung des optischen Bauteils als Strahlumformer sehr scharfkantige Schnittränder erzeugt.

Besonders geeignet ist das mit einem Übergangsbereich versehene, erfindungsgemäße Bauteil auch für eine Verwendung als optische Übertragungsstrecke für hohe Lichtleistungen von einem Niedertemperaturbereich in einen Hochtemperaturbereich bis 1000°C zur Materialbehandlung, wobei mindestens der zylindrische Bereich und der Übergangsbereich des optischen Bauteils im Niedertemperaturbereich angeordnet sind und der zylindrische Bereich einen Durchmesser von höchstens 1500 Mikro-Meter aufweist und wobei ein optisches Übertragungselement aus Quarzglas, dessen kleinste Querschnittsfläche mindestens so groß ist wie die größte Querschnittsfläche des Übergangsbereichs und das zwischen dem Übergangsbereich und dem zu behandelnden Material angeordnet ist, in den Hochtemperaturbereich hineinragt. Diese optische Übertragungsstrecke wird insbesondere zur Behandlung von Materialien, die sich innerhalb heißer Medien befinden eingesetzt. Beispielsweise ist das großvolumige Schweißen erhitzter Metalle oder schlecht wärmeleitender Materialien unter Vermeidung von Restspannungen nach dem Abkühlen, sowie eine laserunterstützte Abscheidung oder Abtragung von chemischen Substanzen auf erhitzten Substraten mit hoher Präzision möglich. Die optische Übertragungsstrecke vereint den Vorteil einer flexiblen Lichtführung mit der Möglichkeit hohe Lichtleistungen in einen Temperaturbereich übertragen zu können, der oberhalb der maximalen Einsatztemperatur flexibler Glas-Bauteile liegt. Umgekehrt ermöglicht die Übertragungsstrecke auch die Übertragung vom zu behandelnden Material abgegebener Lichtleistung aus dem Hochtemperaturbereich in den Niedertemperaturbereich. Dabei hat sich für die Übertragung von Lichtleistungen, die mit einem einzelnen optischen Bauteil nicht übertragbar sind, ein Zusammenfassen mehrerer optischer Bauteile zu einem Bündel bewährt, bei dem die Längsachsen der Bauteile parallel zueinander verlaufen und ihre Stirnflächen beiderseits in gemeinsamen Bauteil-Stirnflächen enden. Dies macht bei weitgehender Beibehaltung der Flexibilität des einzelnen optischen Bauteils für das gesamte Bündel, im Hochtemperaturbereich Lichtleistungen verfügbar, bei deren Übertragung ein einzelnes optisches Bauteil zerstört werden würde.

Ausführungsbeispiele der Erfindung sind in der Zeichnung dargestellt und werden nachstehend näher erläutert. In der Zeichnung zeigt
- Fig. 1a: in schematischer Darstellung ein optisches Bauteil im Längsschnitt,
- Fig. 1b: einen radialen Schichtaufbau im zylindrischen Bereich eines erfindungsgemäßen optischen Bauteils,
- Fig. 2: in schematischer Darstellung einen Querschnitt durch das optische Bauteil in Längsrichtung mit einem vor dem Bauteil angeordneten Filterelement,
- Fig. 3: eine schematische Darstellung der Verwendung des Bauteils als Strahlumformer zur Erzeugung ringförmiger Intensitätsverteilungen, bei Einkopplung paralleler Lichtstrahlen,
- Fig. 4: in schematischer Darstellung eine Draufsicht auf die Einkoppelfläche bei der Verwendung des optischen Bauteils als Strahlumformer zur Erzeugung ringförmiger Intensitätsverteilungen des ausgekoppelten Lichtes bei fokussierter Einkopplung der Lichtstrahlen,
- Fig. 5: eine perspektivische Darstellung des Meßergebnisses einer Intensitätsverteilung an der Auskoppelfläche eines optischen Bauteiles, das wie in Figur 4 dargestellt, angeregt worden ist und
- Fig. 6: eine schematische Darstellung der Verwendung des Bauteils als optische Übertragungsstrecke für hohe Lichtleistungen von einem Niedertemperaturbereich in einen Hochtemperaturbereich.

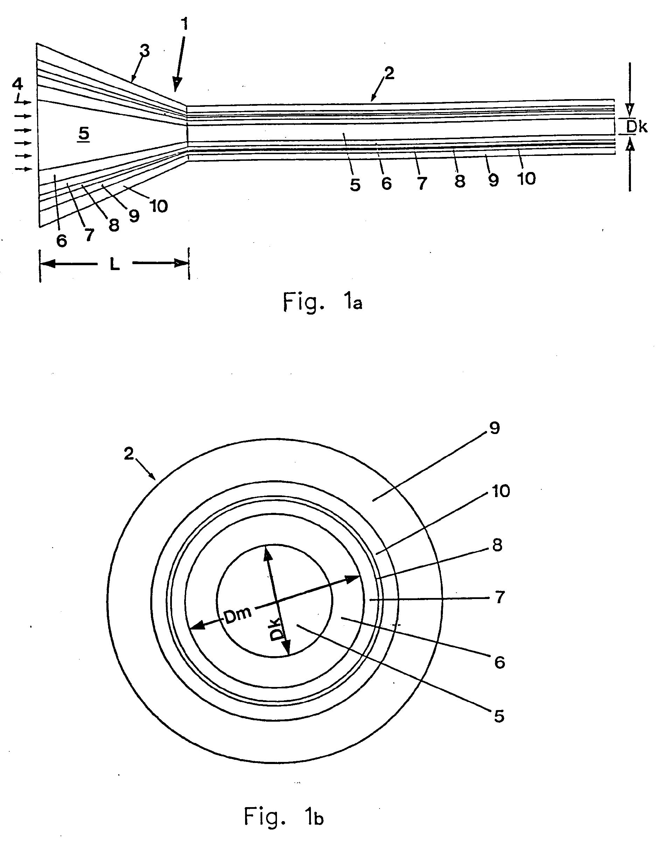

In der Figur 1a ist mit der Bezugsziffer 1 ein erfindungsgemäßes optisches Bauteil bezeichnet, das einen langgestreckten zylindrischen Bereich 2 und einen Verjüngungsbereich 3 umfaßt. Der Verjüngungsbereich 3 ist in Einstrahlrichtung des zu übertragenen, ultravioletten Lichtes gesehen, die mit den Richtungspfeilen 4 gekennzeichnet ist, dem zylindrischen Bereich 2 vorgeordnet und mit diesem verschmolzen. Die Querschnittsfläche des Verjüngungsbereichs 3 ist kreisförmig ausgebildet und nimmt in Einstrahlrichtung 4 gesehen kontinuierlich ab. Die Länge L des Verjüngungsbereichs 3 beträgt 20 mm. Das Bauteil 1 weist einen Kern 5 mit ebenfalls kreisförmigem Querschnitt und einem Durchmesser Dk von 600 Mikro-Meter im zylindrischen Bereich 2 und einen den Kern 5 umhüllenden Mantel 6 auf. Der Kern 5 besteht aus hochreinem synthetischem Quarzglas mit einem Hydroxylgehalt von 650 ppm und einer Konzentration an Wasserstoff von 10¹⁹ Molekülen pro Kubik-Zentimeter. Die nach der Methode von Shelby gemessene Defektkonzentration an Sauerstoffionen liegt unter 10¹⁷ pro Kubik-Zentimeter Kern-Glas 5. Der Mantel 6 besteht aus hochreinem, synthetischen Quarzglas das mit 4 Gewichts-% Fluor dotiert ist und einen Gehalt an Hydroxylionen von etwa 100 ppm aufweist. Aufgrund seiner Fluordotierung hat das Mantel-Glas 6 gegenüber dem Kern-Glas 5 eine um 16x10⁻³ geringere Brechzahl. Die Brechzahlen von Kern- und Mantel-Glas 5,6 nähern sich in einem, in der Zeichnung nicht eingetragenen Zwischenbereich linear einander an, so daß der Querschnitt durch die Schichten von Kern- und Mantel-Glas 5,6 ein mesaförmiges Brechzahlprofil aufweist. Die durch die unterschiedliche Dotierung der beiden Quarzgläser hervorgerufenen Unterschiede in den Viskositäten und in den Ausdehnungskoeffiezienten und die daraus beim Herstellprozeß des Bauteils 1 resultierenden, permanenten Spannungen zwischen Kern- und Mantel-Glas 5,6 werden durch dieses Brechzahlprofil reduziert. Eine aufgrund von Spannungen in den Gläsern 5,6 erhöhte Defektbildungsrate während des praktischen Einsatzes des Bauteils 1 und eine Herabsetzung der Zerstörschwellen für die aufgrund der ultravioletten Lichtstrahlen verursachten Materialschädigungen werden dadurch weitgehend vermieden. Die Dicke des Mantels 6 von 30 Mikro-Meter gewährleistet eine ausreichende Führung der in den Kern 5 eingekoppelten Lichtmoden. Der Mantel-Durchmesser, der mit Dm gekennzeichnet ist beträgt somit 660 Mikro-Meter. Das Verhältnis von Mantel- zu Kerndurchmesser Dm,Dk ist über die gesamte Bauteil-Länge 1 konstant und beträgt 1,1. Um die Flexibilität des Bauteils 1 nicht zu beeinträchtigen, sind die Dicken der das Bauteil 1 aufbauenden Schichten möglichst dünn ausgelegt, jedoch so dick, daß sie ihre Funktion in ausreichendem Maße erfüllen können, wobei sich die nachfolgend genannten Durchmesser- und Dickenangaben auf den zylindrischen Bereich 2 des Bauteils 1 beziehen, wie er in Figur 1b im Querschnitt gezeigt ist. Die das Mantel-Glas 6 umhüllende Druckspannungsschicht 7 besteht ebenfalls aus synthetischem Quarzglas, das jedoch einen Titangehalt von 8 Gewichts-Prozent aufweist. Die Druckspannungsschicht 7 ist die äußerste Glasschicht des Bauteils 1. Durch den Titangehalt wird der Ausdehnungskoeffizient des Quarzglases herabgesetzt, so daß in der Druckspannungsschicht 7 während des Herstellprozesses des Bauteiles 1 Druckspannungen induziert werden, die die Ausbildung von der Oberfläche der Druckspannungsschicht 7 ausgehender Risse verhindern und dadurch die mechanische Stabilität des Bauteils 1 insgesamt erhöhen. Die Dicke der Druckspannungsschicht 7 beträgt 3 Mikro-Meter. Auf die Druckspannungsschicht 7 ist eine reflektierende Goldschicht 8 mit einer Dicke von 0,1 Mikro-Meter aufgetragen. Energiereiches Streulicht, das beispielsweise bei nicht optimierter Anpassung zwischen Bauteil-Geometrie 1 und dem zu übertragenden Lichtstrahl im Einkoppelbereich des Bauteils 1 oder aufgrund von Streuzentren im Bereich geführter Lichtmoden auftritt, würde den Kunststoff der Schutzschicht 9, die das Bauteil 1 vor mechanischer Beschädigung schützen soll, zerstören. Die reflektierende Goldschicht 8 verhindert ein seitliches Austreten von Streulicht aus dem Mantel 6 bzw. aus der Druckspannungsschicht 7 in die Schutzschicht 9 und erhält damit die mechanische Stabilität des optischen Bauteils 1. Da Wasserstoff und Deuterium in der Lage sind, während des Einsatzes des Bauteils für die Übertragung energiereicher, ultravioletter Lichtstrahlen entstehende Materialdefekte teilweise zu neutralisieren, ist es für Langzeitanwendungen des Bauteils 1 erforderlich, die Ausdiffusion des Wasserstoffes aus dem Quarzglas von Kern 5 und Mantel 6 zu hemmen. Dies gewährleistet eine Diffusions-Sperrschicht 10, die mit einer Dicke von 0,2 Mikro-Metern aufgebracht ist und die aus Graphit besteht. Gleichzeitig verhindert die Diffusions-Sperrschicht 10 auch die Eindiffusion unerwünschter Atome oder Moleküle in die Glas-Schichten 5,6,7 des Bauteils 1. Der Kunststoff der Schutzschicht 9 besteht aus einem Fluoropolymer und ist mit einer Dicke von 40 Mikro-Metern aufgetragen. Bei zentrischer und fokussierter Einkopplung von Excimerlaser-Licht ergibt sich auf der Auskoppelfläche eine homogene Leistungsverteilung. Transmissionen von größer 90% bei 20 mJ-Pulsen mit einer Pulslänge von 20 ns werden bei Einkopplung eines fokussierten Laserstrahls mit einem Brennfleckdurchmesser von 550 Mikro-Meter und einer Divergenz kleiner als die numerische Apertur des Bauteils 1 erreicht. Die erzielten Leistungsdichten im zylindrischen Bereich 2 liegen dabei in der Größenordnung der wellenlängenabhängigen Zerstörschwelle des Kern-Glases 5.

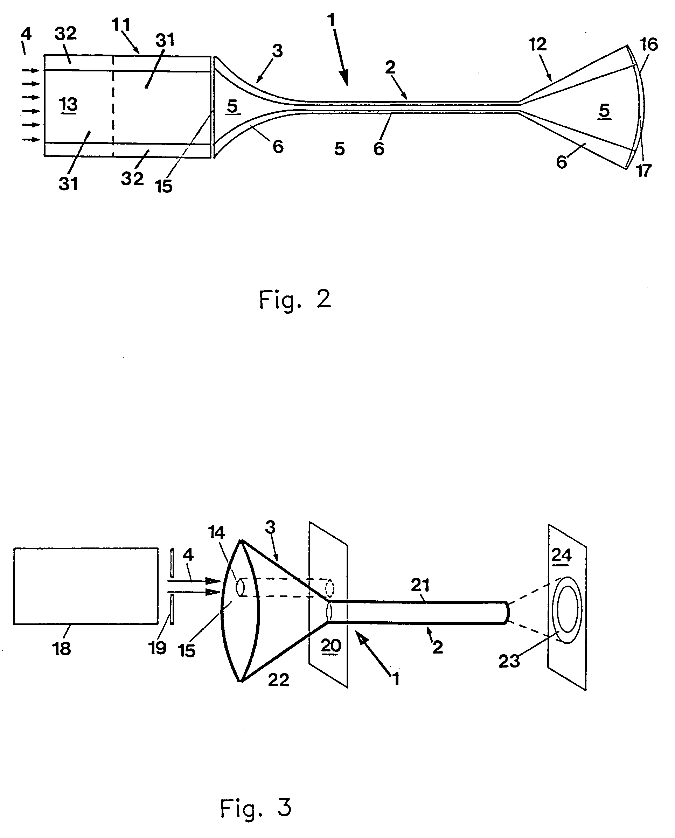

Bei dem in Figur 2 dargestellten Ausführungsbeispiel wird Licht mit einem Wellenlängenspektrum aus dem Ultravioletten und Anteilen aus dem tiefen Ultravioletten, einer Lichtstrahlung, die in Quarzglas nur geringe Eindringtiefen besitzt, aber sehr starke Materialschädigungen verursachen kann, in Einstrahlrichtung 4 in ein zylinderförmiges Filterelement 11 eingekoppelt. Das Filterelement 11 weist einen Kernglasbereich 31 mit einer Querschnittsfläche, die etwas kleiner ist als die Einkoppelfläche 15 des Bauteils 1 und einen, den Kernglasbereich 31 umhüllenden Mantelglasbereich 32 auf. Es hat einen Durchmesser von 3 mm und eine Länge von 10 mm. Das nach dem Filterelement 11 angeordnete optische Bauteil 1 weist in Einstrahlrichtung 4 gesehen einen Verjüngungsbereich 3 mit kreisförmigem Querschnitt und mit einem kontinuierlich sich verjüngenden Durchmesser, einen zylindrischen Bereich 2 und einen Übergangsbereich 12 mit einem sich konisch erweiternden Durchmesser auf. Durch eine Codotierung von 3 ppm Titan zum Quarzglas des Filterelementes 11 wird die Absorptionskante des Quarzglases für das in das Filterelement 11 eingekoppelte ultraviolette Licht zu einer höheren Wellenlänge verschoben. Dadurch wird der Verjüngungsbereich 3 des optischen Bauteils 1 vor den kurzwelligen, besonders energiereichen Anteilen des eingestrahlten ultravioletten Lichtes geschützt. Während der breitbandigen Lichtübertragung mittels der in Fig. 2 dargestellten Anordnung von Bauteil 1 und Filterelement 11 auftretende Materialschädigungen konzentrieren sich im Einkoppelbereich 13 des Filterelements 11, das durch Tempern in wasserstoffhaltiger Atmosphäre regeneriert und erneut eingesetzt oder gegebenenfalls durch ein neues Filterelement 11 ausgetauscht wird. Die das Filterelement 11 verlassenden Lichtstrahlen treffen in einem Ausleuchtungsbereich auf die Einkoppelfläche 15 des Bauteils 1, wobei die Einkoppelfläche 15 mit der Kern-Querschnittsfläche auf der der Lichtquelle zugekehrten Stirnseite des Bauteils 1 identisch ist und um den Faktor 3 größer ist als die Querschnittsfläche des Kerns 5 im zylindrischen Bereich 2 des Bauteils 1 und wobei der Ausleuchtungsbereich das Zentrum der Einkoppelfläche 15 umschließt und ca. 90 Prozent der Einkoppelfläche 15 einnimmt. Aufgrund von Totalreflexion im Bereich der Grenzfläche zwischen Kern 5 und Mantel 3 wird das in die Einkoppelfläche 15 eingekoppelte Licht in den zylinderförmigen Kern 5 überführt, in dessen Anfangsbereich das Licht seine höchste Flächen-Leistungsdichte aufweist. Aufgrund des sich konisch erweiternden Übergangsbereiches 12 und der dadurch bewirkten Aufweitung des geführten Lichtstrahls, ist auch die Auskoppelfläche 16 nur einer gegenüber der Leistungsdichte im zylindrischen Bereich 2 reduzierten optischen Leistungsdichte ausgesetzt. Die Auskoppelfläche 16 ist als konvex gekrümmte Fläche mit einer dielektrischen Entspiegelungsschicht 17 ausgebildet. Aufgrund ihrer konvex ausgebildeten Krümmung, erlaubt die Auskoppelfläche 16 eine fokussierte Auskopplung des übertragenen Lichtstrahls, während die Entspiegelungsschicht 17 die Reflexionsverluste bei der Licht-Auskopplung vermindert und damit zu einem hohen Wirkungsgrad für die Lichtübertragung beiträgt.

Bei der in Figur 3 dargestellten Anordnung zur Verwendung des erfindungsgemäßen Bauteils 1 als Strahlumformer wird ein von einem Xenon-Chlorid-Laser 18 ausgehender Lichtstrahl (Wellenlänge 308 nm, Pulslänge 100 ns, Energie pro Puls 6 mJ, durch Blenden 19 begrenzter Laserstrahl-Durchmesser von 0,6 mm in Richtung der Richtungspfeile 4 in einen Ausleuchtungsbereich 14 der Einkoppelfläche 15 mit einer Flächen-Leistungsdichte von 20 MW/cm² eingekoppelt. Dabei ist die Leistungsdichte im zylindrischen Bereich 2 bzw. an der Auskoppelfläche 16 um eine Größenordnung höher. Die Projektion des Ausleuchtungsbereiches 14 auf eine Ebene 20, die senkrecht zur Mantelfläche 21 des zylindrischen Bereichs 2 verläuft, schneidet sich dabei nicht mit der Projektion der Stirnfläche 22 des zylindrischen Bereichs 2 auf die Ebene 20. Aufgrund dieser Einkopplung in das erfindungsgemäße optische Bauteil 1 wird an der Auskoppelfläche 16 ein ringförmiges Licht-Intensitätsprofil 23 erzeugt, das durch ein in der Figur nicht dargestelltes optisches Abbildungssystem vergrößert und auf einer Projektionswand 24 sichtbar gemacht werden kann.

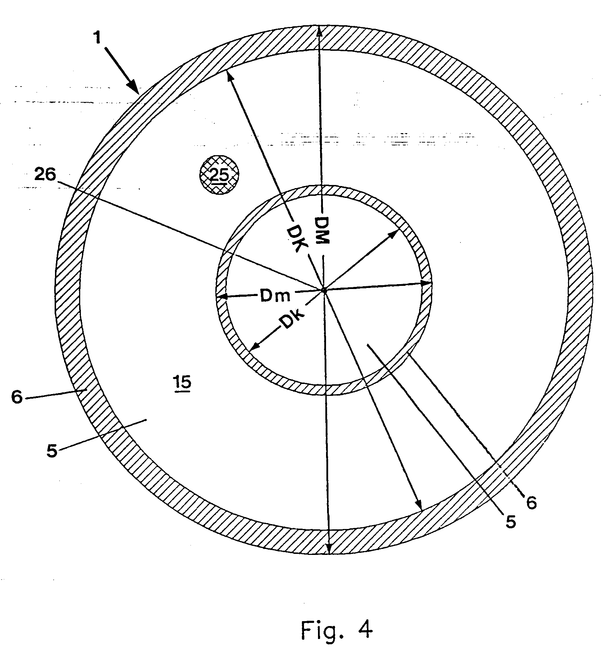

Anhand der in Fig. 4 dargestellten, nicht maßstabsgerechten Draufsicht auf die Einkoppelfläche 15 des optischen Bauteils 1 wird in einem weiteren Ausführungsbeispiel die Verwendung des Bauteils 1 als Strahlumformer bei fokussierter Einkopplung eines Laserstrahls näher erläutert, wobei mit Bezugsziffern bezeichnete Teile, die in Figur 4 nicht erläutert sind, den in Figur 3 mit den gleichen Bezugsziffern bezeichneten Teilen entsprechen. Mit DM ist der Durchmesser der dem Laser zugekehrten Stirnfläche des Verjüngungsbereiches 3 bezeichnet, der 2200 Mikro-Meter beträgt. DK kennzeichnet den Durchmesser der Einkoppelfläche 15 des optischen Bauteils 1. Die Einkoppelfläche 15 entspricht dabei dem Flächenanteil des Kern-Glases 5 an der gesamten Stirnfläche des dem Laser zugewandten Verjüngungsbereiches 3. Sie ist im Ausführungsbeispiel als Fläche mit kreisförmigem Querschnitt mit einem Durchmesser von 2000 Mikro-Meter ausgebildet. Der Durchmesser des Mantels 6 im zylindrischen Bereich 2 beträgt 220 Mikro-Meter und ist mit Dm, der des Kerns 5 beträgt 200 Mikro-Meter und ist mit Dk bezeichnet. Das Verhältnis der Einkoppelfläche 15 zur Kern-Querschnittsfläche des zylindrischen Bereichs 2 beträgt somit 100:1. In einem Ausleuchtungsbereich 14 der Einkoppelfläche 15 des optischen Bauteils 1 wird ein Laserstrahl einfokussiert, dessen Fokus in Einstrahlrichtung 4 gesehen unmittelbar vor der Stirnfläche des zylindrischen Bereiches 2 liegt und der eine im Querschnitt kreisförmige Fokusfläche 25 mit einem Durchmesser von 180 Mikro-Meter einnimmt, wobei die Fokusfläche 25 so liegt, daß sie keinen Schnittpunkt mit der entgegen der Einstrahlrichtung 4 des Laserstrahls bis zur Einkoppelfläche 15 verlängerten Achse 26 des zylindrischen Bereichs 2 aufweist. Der Abstand des Mittelpunktes der Fokusfläche 25 von der bis zur Einkoppelfläche 15 verlängerten Achse 26 des zylindrischen Bereichs 2 beträgt 250 Mikro-Meter.

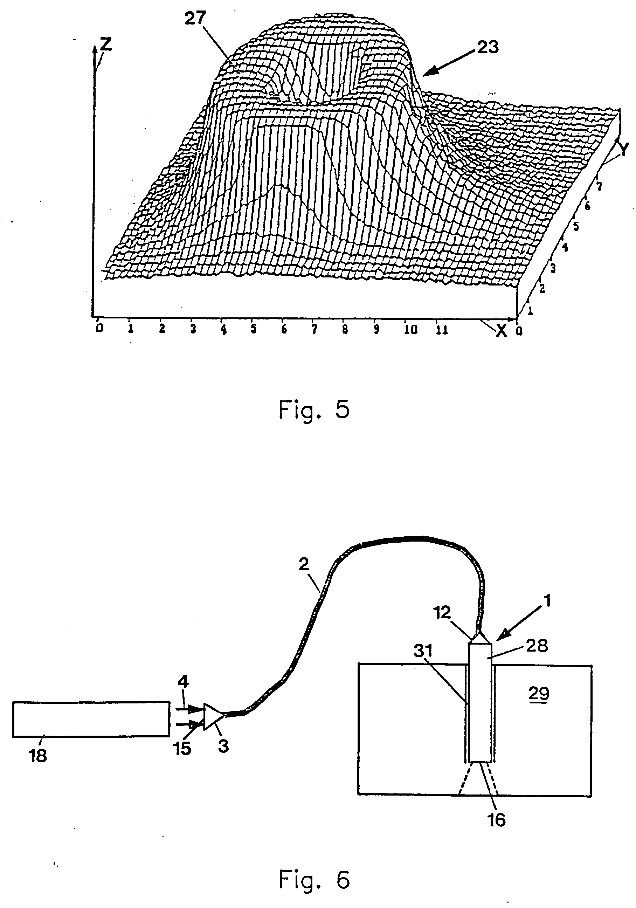

Mit der anhand Fig. 4 erläuterten erfindungsgemäßen Verwendung des optischen Bauteils 1 werden ringförmige Intensitätsprofile 23 des die Auskoppelfläche 16 verlassenden Lichtes erzeugt, wie sie als Meßergebnis mit einem vergrößerten Meßstab in Fig. 5 gezeigt sind. Die mit X bzw. Y bezeichneten, horizontalen Achsen geben dabei die laterale Ausdehnung des gemessenen Licht-Intensitätsprofils 23 im Millimetern an, die mit Z bezeichnete vertikale Achse kennzeichnet die gemessene Licht-Intensität in relativen Einheiten. Das erzeugte Intensitätsprofil weist bei einer Laserausgangspulsenergie von 1,0 mJ, bei einer Pulslänge von 100 ns und einer Wellenlänge von 308 mm in einem gut definierten Ringbereich 27 mit einer Ringbreite von etwa 0,06 mm annähernd gleich hohe Licht-Intensitäten mit Leistungsdichten bis zu 100 MW pro cm² an der Auskoppelfläche des Bauteils auf. Das so erzeugte ringförmige Intensitätsprofil 23 eignet sich insbesondere zum Zweck der Materialbearbeitung für die Erzeugung scharfer Schnittkanten, da bei einer horizontalen Verschiebung des zu schneidenden Materials unter dem Intensitätsprofil 23 hinweg, das die Schnittbreite bestimmende, abzutragende Material, bei konstanter Verschiebegeschwindigkeit annähernd gleichen Leistungsdichten bei annähernd gleichen Verweilzeiten im Bereich der maximalen Leistungsdichten ausgesetzt ist.

Bei dem in Fig. 6 dargestellten Ausführungsbeispiel für eine erfindungsgemäße Verwendung des optischen Bauteils 1 als optische Übertragungsstrecke für die Übertragung hoher Lichtleistungen von einem Bereich bei Raumtemperatur in einen Hochtemperaturbereich zur Materialbehandlung, wird von einem Xenon-Chlorid-Laser 18 erzeugtes, energiereiches Licht mit einer Wellenlänge von 308 nm und einer Laser-Pulsenergie von 25 mJ in Einstrahlrichtung 4 in die Einkoppelfläche 15 des optischen Bauteils 1 eingekoppelt. Das Bauteil 1 weist in Richtung des geführten Strahls gesehen einen sich konisch verjüngenden Verjüngungsbereich 3, einen zylindrischen Bereich 2 mit einem Kerndurchmesser von 600 Mikro-Meter einen sich konisch erweiternden Übergangsbereich 12 und ein als Quarzglas-Zylinder ausgebildetes Übertragungselement 28 auf. Eine Stirnseite des Übertragungselementes 28, das von einer Titan-dotierten Druckspannungsschicht umhüllt ist und einen Außendurchmesser von 2 mm aufweist, ist mit dem Übergangsbereich 12 verbunden, während das Übertragungselement 28 mit der anderen Stirnseite in einen mit Intertgas gefüllten und auf 750°C erhitzten Ofenraum 29 hineinragt, wobei die in den Ofenraum 29 ragende Stirnseite eine Auskoppelfläche 16 aufweist, über die das übertragene, ultraviolette Licht abgegeben und zur laserunterstützten CVD-Abscheidung auf im Ofenraum 29 angeordneten, in der Figur nicht dargestellten, erhitzten Substraten verwendet wird. Um das Übertragungselement 28 vor schädlichen Zugspannungen möglichst zu entlasten, ist sein in den Ofenraum 29 ragender Teil von einer temperaturstabilen Molybdänhülse 30 umhüllt. Der große Durchmesser des Übertragungselementes 28 ermöglicht den Einsatz des Bauteils 1 bei hohen Temperaturen, während die im Raumtemperatur-Bereich angeordneten Abschnitte des optischen Bauteils 1 aufgrund der überwiegend kleinen Querschnittsflächen eine flexible Lichtführung des gesamten optischen Bauteils 1 gewährleisten.

## Patentansprüche

1. Flexibles, optisches Bauteil mit einem Kern und einem diesen umhüllenden, eine kleinere Brechzahl als der Kern aufweisenden Mantel, die im wesentlichen aus Quarzglas bestehen, für die Übertragung von ultraviolettem Licht mit großen Leistungsdichten, das in Einstrahlrichtung des zu übertragenen, ultravioletten Lichtes gesehen vor einem flexiblen, zylindrischen Bereich einen Verjüngungsbereich aufweist, dessen Querschnittsfläche sich in Einstrahlrichtung auf die Querschnittsfläche des zylindrischen Bereichs stetig verkleinert und das eine Einkoppelfläche auf der, einer die ultraviolette Strahlung emittierenden Lichtquelle zugewandten Stirnseite und eine Auskoppelfläche auf der der Lichtquelle abgewandten Stirnseite aufweist, dadurch gekennzeichnet, daß das Kern-Glas (5) einen Gehalt an Hydroxyl-Ionen im Bereich von 50 ppm bis 1200 ppm und eine Sauerstoffionen-Defektkonzentration von weniger als 10¹⁷ pro Gramm Glas und das Mantel-Glas (6) einen Gehalt an Hydroxyl-Ionen im Bereich von 50 ppm bis 250 ppm aufweist, daß die Wasserstoff- und/oder Deuteriumkonzentration im Kern-Glas (5) und im Mantel-Glas (6) in einem Bereich von insgesamt 5x10¹⁶ Molekülen pro Kubik-Zentimeter bis 5x10²¹ Molekülen pro Kubik-Zentimeter liegt, daß die Länge (L) des Verjüngungsbereichs (3) einen Wert zwischen dem 15- bis 150-fachen des Kerndurchmessers (Dk) des zylindrischen Bereichs (2) aufweist und daß das Verhältnis von Einkoppelfläche (15) und Kern-Querschnittsfläche des zylindrischen Bereichs (2) einen Wert zwischen 2 und 100 aufweist.

2. Bauteil nach Anspruch 1, dadurch gekennzeichnet, daß die Länge (L) des Verjüngungsbereichs (3) einen Wert zwischen dem 50- bis 100-fachen des Kerndurchmessers (Dk) im zylindrischen Bereich (2) aufweist.

3. Bauteil nach Anspruch 1 oder 2, dadurch gekennzeichnet, daß das Verhältnis von Einkoppelfläche (15) und Kern-Querschnittsfläche des zylindrischen Bereichs (2), einen Wert zwischen 10 und 50 aufweist.

4. Bauteil nach einem oder mehreren der Ansprüche 1 bis 3, dadurch gekennzeichnet, daß das Mantel-Glas (6) mit Fluor und/oder Bor dotiert ist.

5. Bauteil nach einem oder mehreren der Ansprüche 1 bis 4, dadurch gekennzeichnet, daß das Kern-Glas (5) mit Fluor mit einem Anteil von weniger als 0,5 Gewichts-% dotiert ist, mit der Maßgabe, daß bei ausschließlicher Fluor-Dotierung, der Fluor-Gehalt im Kern-Glas (5) so bemessen ist, daß die notwendige Brechzahldifferenz zwischen Kern-Glas (5) und Mantel-Glas (6) erhalten bleibt.

6. Bauteil nach einem oder mehreren der Ansprüche 1 bis 5, dadurch gekennzeichnet, daß das Verhältnis von Mantel- zu Kerndurchmesser (Dm, Dk) einen Wert im Bereich von 1,02 bis 2,0 aufweist.

7. Bauteil nach Anspruch 6, dadurch gekennzeichnet, daß das Verhältnis von Mantel- zu Kerndurchmesser (Dm,Dk) einen Wert im Bereich von 1,02 bis 1,1 aufweist.

8. Bauteil nach einem oder mehreren der Ansprüche 1 bis 7, dadurch gekennzeichnet, daß sich die Brechzahlen von Mantel- und Kern-Glas (6,5) im Grenzflächenbereich zwischen Mantel (6) und Kern (5) stetig annähern.

9. Bauteil nach einem oder mehreren der Ansprüche 1 bis 8, dadurch gekennzeichnet, daß sich die Querschnittsfläche des Kerns in einem Übergangsbereich (12) auf der der Lichtquelle (18) abgewandten Seite des Bauteils (1) in Richtung der im Bauteil (1) geführten ultravioletten Licht-Strahlung gesehen kontinuierlich vergrößert.

10. Bauteil nach einem oder mehrerender Ansprüche 1 bis 9, dadurch gekennzeichnet, daß die Einkoppelfläche (15) gekrümmt ist.

11. Bauteil nach einem oder mehreren der Ansprüche 1 bis 10, dadurch gekennzeichnet, daß die Auskoppelfläche (16) gekrümmt ist.

12. Bauteil nach den Ansprüchen 1 und/oder 11, dadurch gekennzeichnet, daß die Auskoppelfläche (16) entspiegelt ist.

13. Bauteil nach einem oder mehreren der Ansprüche 1 bis 12, dadurch gekennzeichnet, daß zwischen Lichtquelle (18) und dem Verjüngungsbereich (3) ein Filterelement (11) angeordnet ist, dessen Länge mindestens 10 mm beträgt und dessen Durchmesser mindestens so groß ist wie der größste Durchmesser (DM) des Verjüngungsbereichs (3).

14. Bauteil nach Anspruch 13, dadurch gekennzeichnet, daß Filterelement (11) und Verjüngungsbereich (3) lösbar miteinander verbunden sind.

15. Bauteil nach Anspruch 13 oder 14, dadurch gekennzeichnet, daß das Filterelement (11) Titan-dotiertes Quarzglas enthält.

16. Bauteil nach einem oder mehreren der Ansprüche 1 bis 15, dadurch gekennzeichnet, daß das Bauteil (1) von einer glasigen Druckspannungsschicht (7) ummantelt ist, die einen Titangehalt von mindestens 4 Gewichts-Prozent und von höchstens 15 Gewichts-Prozent aufweist.

17. Bauteil nach einem oder mehreren der Ansprüche 1 bis 16, dadurch gekennzeichnet, daß es eine den Kern (5) und den Mantel (6) umhüllende Diffusions-Sperrschicht (10) aufweist.

18. Bauteil nach Anspruch 17, dadurch gekennzeichnet, daß die Diffusions-Sperrschicht (10) Kohlenstoff oder Metall enthält.

19. Bauteil nach einem oder mehreren der Ansprüche 1 bis 18, dadurch gekennzeichnet, daß es eine äußere, den Kern (5) und den Mantel (6) umhüllende Schutzschicht (9) aus Kunststoff aufweist.

20. Bauteil nach Anspruch 19, dadurch gekennzeichnet, daß der Kunststoff einen Brechungsindex besitzt, der kleiner ist als der des Mantel-Glases (6).

21. Bauteil nach Anspruch 19 oder 20, dadurch gekennzeichnet, daß die Schutzschicht (9) auf die Außenoberfläche einer Metallschicht (8) aufgebracht ist, die den Kern (5) und den Mantel (6) umhüllt und das Licht an ihrer Innen- oberfläche reflektiert.

22. Bauteil nach Anspruch 19 oder 20, dadurch gekennzeichnet, daß die Schutzschicht (9) auf einer Strahlenabschirmschicht aufgebracht ist, die einen Kunststoff enthält, dessen Brechungsindex kleiner ist als der Brechungsindex des Mantel-Glases (6).

23. Bauteil nach Anspruch 9 und nach einem oder mehreren der Ansprüche 1 bis 8 und 10 bis 22, dadurch gekennzeichnet, daß nach dem Übergangsbereich (12) ein Übertragungselement (28) angeordnet ist, dessen kleinste Querschnittsfläche mindestens so groß ist wie die größte Querschnittsfläche des Übergangsbereichs (12).

24. Verwendung des optischen Bauteils nach einem oder mehreren der Ansprüche 1 bis 23 als Strahlumformer zur Materialbehandlung, wobei zur Erzeugung einer ringförmigen Intensitätsverteilung (23) des übertragenen ultravioletten Lichtes an der Auskoppelfläche (16) ein paralleles Lichtbündel in einen Ausleuchtungsbereich (14) der Einkoppelfläche (15) eingekoppelt wird, wobei die Projektion des Ausleuchtungsbereichs (14) auf eine Ebene (20), die senkrecht zur Längsachse des zylindrischen Bereichs (2) verläuft, die Querschnittsfläche des zylindrischen Bereichs (2) in dieser Ebene (20) höchstens 50 % überschneidet.

25. Verwendung des optischen Bauteils nach einem oder mehreren der Ansprüche 1 bis 23 als Strahlumformer zur Materialbehandlung, wobei zur Erzeugung einer ringförmigen Intensitätsverteilung (23) des zu übertragenden ultravioletten Lichtes an der Auskoppelfläche (16) ein fokussiertes Lichtbündel in die Einkoppelfläche (15) so eingekoppelt wird, daß die bis zur Einkoppelfläche (15) verlängerte Achse (26) des zylindrichen Bereichs (2) die Fläche des zwischen Einkoppelfläche (15) und zylindrischem Bereich (2) befindlichen Lichtbündel-Brennpunktes (25) nicht schneidet.

26. Verwendung des optischen Bauteils nach Anspruch 23 als optische Übertragungsstrecke für hohe Lichtleistungen von einem Niedertemperaturbereich in einen Hochtemperaturbereich (29) bis 1000° C, zur Materialbehandlung, wobei mindestens der flexible, zylindrische Bereich (2) und der Übergangsbereich (12) im Niedertemperaturbereich angeordnet sind und der zylindrische Bereich (2) einen Durchmesser (Dm) von höchstens 1500 Mikro-Meter aufweist und wobei das optische Übertragungselement (28) aus Quarzglas in den Hochtemperaturbereich (29) hineinragt.

## Claims

1. Flexible optical member with a core, and a convex sheath surrounding this core and having a smaller refractive index than said core, consisting essentially of quartz glass, for transmitting ultraviolet light at high power intensities, which optical member has, in the direction of passage of the ultraviolet light to be transmitted, and upstream of a flexible cylindrical region, a reducing region, the cross-sectional area of which diminishes steadily in the direction of passage down to the cross-sectional area of the cylindrical region and further has an entry surface at the face turned towards the light source emitting the ultraviolet rays and an exit surface at the face remote from the light source, characterised in that the core glass (5) has a hydroxyl-ion content of around 50 ppm to 1200 ppm and an anion deficit concentration of less than 10¹⁷ per gram of glass, and the sheath glass (6) has a hydroxyl-ion content of around 50 ppm to 250 ppm, in that the concentration of oxygen and/or deuterium in the core glass (5) and in the sheath glass (6) lies, in total, between 5x10¹⁶ molecules per cubic centimetre and 5x10²¹ molecules per cubic centimetre, in that the length (L) of the reducing region (3) has a value between 15 and 150 times the core diameter (Dk) of the cylindrical region (2), and in that the ratio of the entry surface (15) and the core-cross-sectional area of the cylindrical region (2) has a value between 2 and 100.

2. Member according to Claim 1, characterised in that the length (L) of the reducing region (3) has a value between 50 and 100 times the core diameter (Dk) in the cylindrical region (2).

3. Member according to Claim 1 or 2, characterised in that the ratio of the entry surface (15) and the core-cross-sectional area of the cylindrical region (2) has a value between 10 and 50.

4. Member according to one or more of Claims 1 to 3, characterised in that the sheath glass (6) is doped with fluorine and/or boron.

5. Member according to one or more of Claims 1 to 4, characterised in that the core glass (5) is doped with fluorine in a quantity less than 0.5% by weight, on condition that when doping is exclusively with fluorine the fluorine content in the core glass (5) is determined such that the necessary difference in refractive index between the core glass (5) and the sheath glass (6) is retained.

6. Member according to one or more of Claims 1 to 5, characterised in that the ratio of the sheath diameter to the core diameter (Dm, Dk) has a value of around 1.02 to 2.0.

7. Member according to Claim 6, characterised in that the ratio of the sheath diameter to the core diameter (Dm, Dk) has a value of around 1.02 to 1.1.

8. Member according to one or more of Claims 1 to 7, characterised in that the refractive indices of the sheath glass and the core glass (6, 5) approach one another steadily at the interface between the sheath (6) and the core (5).

9. Member according to one or more of Claims 1 to 8, characterised in that the cross-sectional area of the core increases continuously in a transition region (12) at the end of the member (1) remote from the light source (18), in the direction of transmission of the ultraviolet-light radiation in the member (1).

10. Member according to one or more of Claims 1 to 9, characterised in that the entry surface (15) is curved.

11. Member according to one or more of Claims 1 to 10, characterised in that the exit surface (16) is curved.

12. Member according to Claims 1 and/or 11, characterised in that the exit surface (16) is anti-reflective.

13. Member according to one or more of Claims 1 to 12, characterised in that between the light source (18) and the reducing region (3) a filter element (11) is disposed, the length of which is at least 10 mm and the diameter of which is at least as large as the greatest diameter (DM) of the reducing region (3).

14. Member according to Claim 13, characterised in that the filter element (11) and the reducing region (3) are connected to each other detachably.

15. Member according to Claim 13 or 14, characterised in that the filter element (11) contains titanium-doped quartz glass.

16. Member according to one or more of Claims 1 to 15, characterised in that the member (1) is coated with a vitreous layer (7) for bearing compressive stress, which layer has a titanium content of at least 4 per cent by weight and of at most 15 per cent by weight.

17. Member according to one or more of Claims 1 to 16, characterised in that it has a diffusion-blocking layer (10) enveloping the core (5) and the sheath (6).

18. Member according to Claim 17, characterised in that the diffusion-blocking layer (10) contains carbon or metal.

19. Member according to one or more of Claims 1 to 18, characterised in that it has an outer protective layer (9) of synthetic material enveloping the core (5) and the sheath (6).

20. Member according to Claim 19, characterised in that the synthetic material has an index of refraction lower than that of the sheath glass (6).

21. Member according to Claim 19 or 20, characterised in that the protective layer (9) is applied to the outer surface of a metallic layer (8) which envelops the core (5) and the sheath (6) and reflects light on its inner surface.

22. Member according to Claim 19 or 20, characterised in that the protective layer (9) is applied to a ray-screening layer that contains a synthetic material, the index of refraction of which is lower than the index of refraction of the sheath glass (6).

23. Member according to Claim 9 and according to one or more of Claims 1 to 8 and 10 to 22, characterised in that beyond the transition region (12) a transmission element (28) is disposed, the smallest cross-sectional area of which is at least as large as the largest cross-sectional area of the transition region (12).

24. Use of the optical member according to one or more of Claims 1 to 23 as a ray transducer in the processing of material, wherein, in order to produce a circular intensity distribution (23) of the transmitted ultraviolet light at the exit surface (16), a parallel light beam is introduced into an illumination area (14) of the entry surface (15), whereof the projection of the illumination area (14) on to a plane (20) perpendicular to the longitudinal axis of the cylindrical region (2) overlaps the cross-sectional area of the cylindrical region (2) in this plane (20) by not more than 50%.

25. Use of the optical member according to one or more of Claims 1 to 23 as a ray transducer for the processing of material, wherein, in order to produce at the exit surface (16) a circular intensity distribution (23) of the ultraviolet light to be transmitted, a focussed light beam is introduced at the entry surface (15) such that the longitudinal axis (26) of the cylindrical region (2) projected on to the entry surface (15) does not intersect the region of the light-beam focal point (25) located between the entry surface (15) and the cylindrical region (2).

26. Use of the optical member according to Claim 23 as an optical transmitter of high light efficiency from a low-temperature zone to a high-temperature zone (29) of up to 1000° C, for processing material, wherein at least the flexible cylindrical region (2) and the transition region (12) are disposed in the low-temperature zone and the cylindrical region (2) has a diameter (Dm) of no more than 1500 micrometres, and wherein the optical transmission element (28) of quartz glass extends into the high-temperature zone (29).

## Revendications

1. Composant optique flexible comportant un noyau et une enveloppe entourant celui-ci et présentant un indice de réfraction inférieur à celui du noyau, constitués essentiellement de verre quartzeux, destiné à la transmission de lumière ultraviolette à densités de puissance élevée, qui, vu en direction de rayonnement de la lumière ultraviolette à transmettre, présente devant une zone cylindrique flexible une zone de rétrécissement dont la surface diminue de façon constante en direction de rayonnement pour atteindre la surface de la section de la zone cylindrique, et qui présente une surface de couplage d'entrée sur la face frontale orientée vers la source de lumière émettant un rayonnement ultraviolet et une surface de couplage de sortie sur la face frontale opposée à la source de lumière, caractérisé en ce que le verre du noyau (5) présente une teneur en ions hydroxyles dans la plage de 50 ppm à 1200 ppm et une concentration de lacunes d'ions d'oxygène de moins de 10¹⁷ par gramme de verre et en ce que le verre de l'enveloppe (6) présente une teneur en ions hydroxyles dans une plage de 50 ppm à 250 ppm, en ce que la concentration d'hydrogène et/ou de deutérium dans le verre du noyau (5) et dans le verre de l'enveloppe (6) est située dans une gamme d'au total 5x10¹⁶ molécules par centimètre cube jusqu'à 5x10²¹ molécules par centimètre cube, en ce que la longueur (L) de la zone de rétrécissement (3) a une valeur se situant entre 15 à 150 fois le diamètre du noyau (Dk) de la zone cylindrique (2) et en ce que le rapport entre la surface de couplage d'entrée (15) et la surface transversale de noyau de la zone cylindrique (2) a une valeur entre 2 et 100.

2. Composant selon la revendication 1, caractérisé en ce que la longueur (L) de la zone de rétrécissement (3) a une valeur entre 50 à 100 fois le diamètre du noyau (Dk) dans la zone cylindrique (2).

3. Composant selon la revendication 1 ou 2, caractérisé en ce que le rapport entre la surface de couplage d'entrée (15) et la surface de la section du noyau de la zone cylindrique (2) a une valeur entre 10 et 50.

4. Composant selon l'une quelconque ou plusieurs des revendications 1 à 3, caractérisé en ce que le verre de l'enveloppe (6) est dopé de fluor et/ou de bore.

5. Composant selon l'une quelconque ou plusieurs des revendications 1 à 4, caractérisé en ce que le verre du noyau (5) est dopé d'une part de fluor de moins de 0,5 % en poids, sous réserve qu'en cas de dopage de fluor exclusif, la teneur en fluor dans le verre du noyau (5) est choisie de telle manière que la différence d'indice de réfraction nécessaire entre le verre du noyau (5) et le verre de l'enveloppe (6) est maintenue.

6. Composant selon l'une quelconque ou plusieurs des revendications 1 à 5, caractérisé en ce que le rapport entre le diamètre de l'enveloppe et celui du noyau (Dm, Dk) a une valeur de l'ordre de 1,02 à 2,0.

7. Composant selon la revendication 6, caractérisé en ce que le rapport entre le diamètre de l'enveloppe et celui du noyau (Dm, Dk) a une valeur de l'ordre de 1,02 à 1,1.

8. Composant selon l'une quelconque ou plusieurs des revendications 1 à 7, caractérisé en ce que les indices de réfraction du verre de l'enveloppe et du noyau (6, 5) se rapproche de façon constante dans la région d'interface entre l'enveloppe (6) et le noyau (5).

9. Composant selon l'une quelconque ou plusieurs des revendications 1 à 8, caractérisé en ce que vue en direction du rayonnement lumineux ultraviolet guidé dans le composant (1), la surface de la section du noyau s'agrandit de manière continue dans une zone de transition (12) sur la face du composant (1) opposée à la source de lumière (18).

10. Composant selon l'une quelconque ou plusieurs des revendications 1 à 9, caractérisé en ce que la surface de couplage d'entrée (15) est courbe.

11. Composant selon l'une quelconque ou plusieurs des revendications 1 à 10, caractérisé en ce que la surface de couplage de sortie (16) est courbe.

12. Composant selon les revendications 1 et/ou 11, caractérisé en ce que la surface de couplage d'entrée (16) est antireflet.

13. Composant selon l'une quelconque ou plusieurs des revendications 1 à 12, caractérisé en ce que entre la source de lumière (15) et la zone de rétrécissement (3) est agencé un élément de filtre (11) dont la longueur est d'au moins 10 mm et dont le diamètre est au moins aussi grand que le plus grand diamètre (DM) de la zone de rétrécissement (3).

14. Composant selon la revendication 13, caractérisé en ce que l'élément de filtre (11) et la zone de rétrécissement (3) sont reliés l'un à l'autre de manière amovible.

15. Composant selon la revendication 13 ou 14, caractérisé en ce que l'élément de filtre (11) comprend du verre quartzeux dopé de titane.

16. Composant selon l'une quelconque ou plusieurs des revendications 1 à 15, caractérisé en ce que le composant (1) est enveloppé d'une couche de tension de compression (7) vitreuse qui présente une teneur en titane au moins de 4 % en poids et au plus de 15 % en poids.

17. Composant selon l'une quelconque ou plusieurs des revendications 1 à 16, caractérisé en ce qu'il présente une couche anti-diffusion (10) entourant le noyau (5) et le manteau (6).

18. Composant selon la revendication 17, caractérisé en ce que la couche anti-diffusion (10) comporte du carbone ou du métal.

19. Composant selon l'une quelconque ou plusieurs des revendications 1 à 18, caractérisé en ce qu'il présente une couche de protection (9) en matière plastique entourant le noyau (5) et le manteau (6).

20. Composant selon la revendication 19, caractérisé en ce que la matière plastique possède un indice de réfraction qui est inférieur à celui du verre de l'enveloppe (6).

21. Composant selon la revendication 19 ou 20 caractérisé en ce que la couche de protection (9) est appliquée sur la surface extérieure d'une couche métallique (8) qui entoure le noyau (5) et l'enveloppe (6) et reflète la lumière sur sa surface interne.

22. Composant selon la revendication 19 ou 20, caractérisé en ce que la couche de protection (9) est appliquée sur une couche écran anti-rayonnement qui contient une matière plastique dont l'indice de réfraction est inférieur à l'indice de réfraction du verre de l'enveloppe (6).

23. Composant selon la revendication 9 et selon l'une quelconque ou plusieurs des revendications 1 à 8 et 10 à 22, caractérisé en ce qu'après la zone de transition (12) est agencé un élément de transmission (28) dont la surface de section la plus petite est au moins aussi grande que la surface de section la plus grande de la zone de transition (12).

24. Utilisation du composant optique selon l'une quelconque ou plusieurs des revendications 1 à 23 en tant que convertisseur de rayonnement pour le traitement de matériaux, un faisceau lumineux parallèle étant couplé en entrée dans une zone d'éclairage (14) de la surface de couplage d'entrée (15) pour produire une répartition annulaire (23) d'intensité de la lumière ultraviolette transmise sur la surface de couplage de sortie (16), la projection de la zone d'éclairage (14) sur un plan (20), qui s'étend perpendiculairement à l'axe longitudinal de la zone cylindrique (2), chevauchant tout au plus de 50 % la surface de section de la zone cylindrique (2) dans ce plan (20).

25. Utilisation du composant optique selon l'une quelconque ou plusieurs des revendications 1 à 23 en tant que convertisseur de rayonnement pour le traitement de matériaux, un faisceau lumineux focalisé étant introduit dans la surface de couplage d'entrée (15) pour produire une répartition annulaire (23) de l'intensité de la lumière ultraviolette à transmettre sur la surface de couplage de sortie (16), de telle sorte que l'axe 26 de la zone cylindrique (2) prolongé jusqu'à la surface de couplage d'entrée (15) ne coupe pas la surface du foyer (25) du faisceau lumineux se trouvant entre la surface de couplage d'entrée (15) et la région cylindrique (2).

26. Utilisation du composant optique selon la revendication 23 en tant que voie de transmission optique pour des puissances lumineuses élevées allant d'une zone de basse température vers une zone de haute température (29) atteignant 1000°C, dans le but de traiter des matériaux, au moins la région cylindrique (2) flexible et la zone de transition (12) étant agencées dans la zone de basse température et la zone cylindrique (2) présentant un diamètre (Dm) d'au plus 1500 micromètres et l'élément de transmission optique (28) en verre quartzeux pénétrant dans la zone de haute température (29).
